# EUROPEAN PATENT APPLICATION

(11) **EP 4 321 931 A1**
(43) Date of publication of application: **14.02.2024**
(21) Application number: 22784593.0
(22) Date of filing: 30.03.2022
(51) Int. Cl.: G03F 1/64, C09J 7/38

(54) **PELLICLE FRAME, PELLICLE, PHOTOMASK WITH PELLICLE, EXPOSURE METHOD, METHOD FOR MANUFACTURING SEMICONDUCTOR DEVICE, AND METHOD FOR MANUFACTURING LIQUID CRYSTAL DISPLAY**

(30) Priority: 05.04.2021 JP 2021064107
(71) Applicant: SHIN-ETSU CHEMICAL CO., LTD., Tokyo 1000005 (JP)
(72) Inventor: NISHIMURA, Akinori, Annaka-shi, Gunma 379-0127 (JP)
(74) Representative: Meissner Bolte Partnerschaft mbB
(86) International application number: PCT/JP2022/015777
(87) International publication number: WO 2022/215609

(57) **Abstract**

The purpose of the present invention is to provide a pellicle frame with an adhesive layer with which it is possible to prevent deterioration in the flatness of the adhesive layer more effectively than before, further to moderate the stress applied by a pellicle to a photomask, and as a result to reduce pellicle induced distortion (PID). The present invention provides a pellicle frame with an adhesive layer having one end surface on which a pellicle film is provided and another end surface provided with an adhesive layer for adhesion to a photomask, wherein the adhesive layer has a thickness of 0.10 to 0.30 mm, and the adhesive layer has an adhesive force of 5×10⁻³ to 5×10⁻¹ N/cm. The present invention also provides a pellicle provided with a pellicle film on the one end surface.

## Description

### TECHNICAL FIELD

The present invention relates to a pellicle frame used as a dust guard in manufacturing a semiconductor device, a printed circuit board, a liquid crystal display, and the like, and also to a pellicle, a photomask with a pellicle, an exposure method, a method for manufacturing a semiconductor device, and a method of manufacturing a liquid crystal display.

### BACKGROUND ART

In manufacturing semiconductors such as LSI and VLSI and manufacturing a liquid crystal display or the like, a pattern is formed by irradiating a semiconductor wafer or an original plate for liquid crystals with light. In this process, dust adheres to a photomask or a reticle used (hereinafter, simply described as a photomask), causing a problem of impaired dimensions, quality, and appearance such as a rough edge or a black and dirty base.

Although these operations are typically performed in a clean room, it is still difficult to keep the photomask clean at all times, and therefore a pellicle is attached to the surface of the photomask as a dust guard before exposure. In this case, foreign matters do not directly adhere to the surface of the photomask but adhere to the pellicle, and thus if the focus is set on the pattern of the photomask at the time of lithography, the foreign matters on the pellicle are irrelevant to the transfer.

In general, the pellicle is obtained by bonding a transparent pellicle film made of nitrocellulose, cellulose acetate, a fluororesin, or the like which transmits light well to an upper end face of a pellicle frame made of aluminum, stainless steel, polyethylene, or the like by air-drying a solvent that has been applied thereon and can well dissolve the pellicle film, or bonding with an adhesive agent such as an acrylic resin, epoxy resin, or the like. Further, the lower end of the pellicle frame includes a pressure-sensitive adhesive agent layer made of a polybutene resin, a polyvinyl acetate resin, an acrylic resin, a silicone resin, or the like for adhesion to a photomask, and a release layer (separator) for protecting the pressure-sensitive adhesive agent layer.

When such a pellicle is attached to the surface of the photomask and a photoresist film formed on a semiconductor wafer or an original plate for liquid crystals is exposed through the photomask, foreign matters such as dust adhere to the surface of the pellicle and do not adhere directly to the surface of the photomask. Therefore, if light for exposure is applied so that a focal point is located on a pattern formed on the photomask, the influence of foreign matters such as dust can be avoided.

In recent years, semiconductor devices and liquid crystal displays have been increasingly highly integrated and miniaturized. Currently, a technique for forming a fine pattern of about 32 nm on a photoresist film is also put into practical use. The pattern of about 32 nm can be formed by an immersion exposure technique in which a space between a semiconductor wafer or an original plate for liquid crystals and a projection lens is filled with a liquid such as ultrapure water, and an argon fluoride (ArF) excimer laser is used to expose a photoresist film, or by an improved technique using a conventional excimer laser such as multiple exposure.

However, next generation semiconductor devices and liquid crystal displays are required to form finer patterns, and using the conventional pellicle and exposure techniques becomes difficult to form finer patterns.

Therefore, in recent years, as a method for forming a finer pattern, an EUV exposure technique using EUV light having a main wavelength of 13.5 nm has attracted attention.

Meanwhile, as semiconductor devices and liquid crystal displays are miniaturized, a major problem arises in the pellicle, which determines a yield, because the pellicle is attached to a photomask, the photomask is distorted by stress (pellicle induced distortion (PID)), and positional accuracy of a formed pattern is deviated, which makes it difficult to form a fine pattern.

In a general pellicle, a pressure-sensitive adhesive agent layer is provided over the entire periphery of a lower end face of a pellicle frame, and when the pellicle and a photomask are attached, the photomask receives stress from the entire one end face of the pellicle frame, and the stress causes a problem of a distorted photomask. If the photomask is distorted by the stress applied from the pellicle frame, it is difficult to form an intended fine pattern depending on the degree of distortion.

To minimize distortion of the photomask, Patent Document 1 proposes a pellicle in which the adhesive force of the pressure-sensitive adhesive agent layer is suppressed to be low. However, even this pellicle also has such a problem that the adhesion between the photomask and the pellicle is weakened depending on the thickness of the pressure-sensitive adhesive agent layer, and the pellicle falls from the photomask.

### PRIOR ART DOCUMENTS

### PATENT DOCUMENTS

Patent Document 1: JP-A 2012-108277

### SUMMARY OF INVENTION

### TECHNICAL PROBLEM

The present invention has been made in view of the above circumstances, and an object of the present invention is to provide a pellicle frame with a pressure-sensitive adhesive agent layer that can reduce stress transmitted from the pellicle frame to the photomask and suppress distortion of the photomask when the pellicle frame and the photomask are bonded, and also to provide a pellicle, a photomask with a pellicle, an exposure method, a method for manufacturing a semiconductor device, and a method for manufacturing a liquid crystal display.

### SOLUTION TO PROBLEM

The present inventor has extensively investigated for achieving the above object, and found that reducing the thickness of a pressure-sensitive adhesive agent layer provided on a lower end face of a pellicle frame and reducing the adhesive force can ensure suppression of deterioration of the flatness of the pressure-sensitive adhesive agent, deformation stress from the pellicle frame to the pressure-sensitive adhesive agent generated when a pellicle is attached to a photomask is less likely to be held in the pressure-sensitive adhesive agent, and as a result, a change in shape of the mask is also suppressed, leading to the present invention.

Therefore, the present invention provides a pellicle frame with a pressure-sensitive adhesive agent layer, a pellicle, a photomask with a pellicle, an exposure method, a method for manufacturing a semiconductor device, and a method for manufacturing a liquid crystal display described below.
1. A pellicle frame with a pressure-sensitive adhesive agent layer, the pellicle frame having one end face on which a pellicle film is provided and another end face on which a pressure-sensitive adhesive agent layer to be attached to a photomask is provided, wherein the pressure-sensitive adhesive agent layer has a thickness of 0.10 to 0.30 mm, and the pressure-sensitive adhesive agent layer has an adhesive force of from 5×10⁻³ to 5×10⁻¹ N/cm.
2. The pellicle frame with a pressure-sensitive adhesive agent layer of 1, wherein the pressure-sensitive adhesive agent layer contains an acrylic-based pressure-sensitive adhesive agent.
3. The pellicle frame with a pressure-sensitive adhesive agent layer of 1, wherein the pressure-sensitive adhesive agent layer contains a silicone-based pressure-sensitive adhesive agent.
4. The pellicle frame with a pressure-sensitive adhesive agent layer of any one of 1 to 3, wherein a peelable separator is provided on a surface of the pressure-sensitive adhesive agent layer.
5. A pellicle, wherein a pellicle film is provided on the one end face of the pellicle frame with a pressure-sensitive adhesive agent layer of any one of 1 to 4.
6. A photomask with a pellicle, wherein the pellicle of 5 is provided on a photomask.
7. An exposure method, wherein exposure is performed with the photomask with a pellicle of 6.
8. A method for manufacturing a semiconductor device, the method comprising a step of performing exposure with the photomask with a pellicle of 6.
9. A method for manufacturing a liquid crystal display, the method comprising a step of performing exposure with the photomask with a pellicle of 6.

### ADVANTAGEOUS EFFECTS OF INVENTION

The pellicle frame with a pressure-sensitive adhesive agent layer according to the present invention can suppress deterioration of flatness of the pressure-sensitive adhesive agent layer as compared with conventional ones, and can further alleviate stress applied from the pellicle to the photomask, and as a result, can suppress PID. Therefore, the pellicle frame with a pressure-sensitive adhesive agent layer according to the present invention is particularly effective as a pellicle to be used for a recently miniaturized pattern in which PID performance is regarded as the most important, and is useful for an exposure method using a photomask with a pellicle, a method for manufacturing a semiconductor device, and a method for manufacturing a liquid crystal display, the methods using such a pellicle.

### DESCRIPTION OF EMBODIMENTS

Hereinafter, the present invention is described in more detail.

The pellicle frame according to the present invention is a pellicle frame with a pressure-sensitive adhesive agent layer, the pellicle frame having one end face on which a pellicle film is provided and the other end face on which the pressure-sensitive adhesive agent layer to be attached to a photomask is provided.

As a material of the pellicle frame, there can be used a known material such as metal or alloy such as aluminum alloy, steel, stainless steel, brass, invar, or super invar, engineering plastic such as PE, PA, or PEEK, or a fiber composite material such as GFRP or CFRP.

In addition, it is preferable that the surface of the pellicle frame is treated to be black and is subjected to surface treatment such as coating for preventing generation of dust as necessary. For example, in the case of using an aluminum alloy, it is preferable to perform surface treatment such as alumite treatment or chemical conversion treatment, and in the case of steel, stainless steel, or the like, it is preferable to perform surface treatment such as black chromium plating.

A pressure-sensitive adhesive agent layer for attaching to a substrate of a photomask is provided on a lower end face of the pellicle frame (that is, provided on one end face of the pellicle frame, whereas a pellicle film is provided on the other end face).

The thickness of the pressure-sensitive adhesive agent layer ranges from 0.10 to 0.30 mm, preferably from 0.10 to 0.20 mm. In the case of forming the pressure-sensitive adhesive agent layer, it is preferable to perform flattening treatment to press the pressure-sensitive adhesive agent layer against a quartz substrate or the like from the viewpoint of the manufacturing process. This improves flatness of the pressure-sensitive adhesive agent layer, and can suppress mask distortion due to attachment of the pellicle to the photomask. If the thickness of the pressure-sensitive adhesive agent layer is small, interface fracture is more dominant than cohesive fracture (elongation of the pressure-sensitive adhesive agent layer) when the pellicle is peeled off from the quartz substrate or the like, and deformation of the pressure-sensitive adhesive agent layer is suppressed. On the other hand, if the thickness of the pressure-sensitive adhesive agent layer is large, the viscous resistance in peeling off the pellicle from the quartz substrate or the like becomes small, so that cohesive fracture becomes more dominant than interface fracture, and deformation of the pressure-sensitive adhesive agent becomes remarkable. In this case, the deformation stress transmitted to the photomask increases, and the photomask is easily distorted.

The adhesive force of the pressure-sensitive adhesive agent layer ranges from 5×10⁻³ to 5×10⁻¹ N/cm, preferably from 5×10⁻³ to 1×10⁻¹ N/cm. The lower limit may be 5×10⁻² N/cm. If the adhesive force is small, the deformation stress transmitted to the photomask is small, but if the adhesive force is less than 5×10⁻³ N/cm and is too small, the adhesion to the photomask is weak, and a pellicle may fall from the photomask. On the other hand, it is not preferable that the adhesive force is more than 5×10⁻¹ N/cm because the photomask is easily distorted. This is considered to be because the shape of the pellicle, in particular, the pellicle frame affects the shape of the photomask, and if the adhesive force is large, the shape change due to the deformation stress is maintained.

In addition, from the viewpoint of the adhesive force and the distortion resistance of the photomask, the following conditions (1) to (4) are preferable.
(1) If the thickness of the pressure-sensitive adhesive agent layer is 0.10 mm or more and less than 0.15 mm, the adhesive force of the pressure-sensitive adhesive agent layer is preferably from 5×10⁻³ to 5×10⁻¹ N/cm, more preferably from 5×10⁻³ to 1×10⁻¹ N/cm, and particularly preferably from 5×10⁻³ to 5×10⁻² N/cm.
(2) If the thickness of the pressure-sensitive adhesive agent layer is 0.15 mm or more and less than 0.20 mm, the adhesive force of the pressure-sensitive adhesive agent layer is preferably from 5×10⁻³ to 5×10⁻¹ N/cm, more preferably from 5×10⁻³ to 1×10⁻¹ N/cm, and particularly preferably from 5×10⁻³ to 5×10⁻² N/cm.
(3) If the thickness of the pressure-sensitive adhesive agent layer is 0.20 mm or more and less than 0.25 mm, the adhesive force of the pressure-sensitive adhesive agent layer is preferably from 5×10⁻³ to 5×10⁻¹ N/cm, more preferably from 5×10⁻³ to 1×10⁻¹ N/cm, and particularly preferably from 5×10⁻³ to 5×10⁻² N/cm.
(4) If the thickness of the pressure-sensitive adhesive agent layer is 0.25 mm or more and 0.30 mm or less, the adhesive force of the pressure-sensitive adhesive agent layer is preferably from 5×10⁻³ to 5×10⁻¹ N/cm, more preferably from 5×10⁻³ to 1×10⁻¹ N/cm, and particularly preferably from 5×10⁻³ to 5×10⁻² N/cm.

The adhesive force of the pressure-sensitive adhesive agent layer can be evaluated in accordance with testing methods of pressure-sensitive adhesive tapes and sheets defined in JIS Z 0237: 2009. Specifically, an adhesive film obtained by applying a pressure-sensitive adhesive agent is bonded to a non-tin surface of soda lime glass, which has been washed with acetone, with a pressure-sensitive adhesive roller, and subjected to autoclave treatment under conditions of 50°C and 0.5 MPa for 20 minutes, and then the adhesive film is returned to an atmosphere of 23°C and 50% RH, and after a lapse of 1 hour, the peel strength of the adhesive film can be represented by an adhesive force (unit: N/cm) when the adhesive film is peeled off at a speed of 5 mm/sec in a 180° direction by a tensile tester in accordance with JIS Z 0237 "Testing methods of pressure-sensitive adhesive tapes and sheets".

As a material of the pressure-sensitive adhesive agent layer, there can be used a known material such as a rubber-based pressure-sensitive adhesive agent, a urethane-based pressure-sensitive adhesive agent, an acrylic-based pressure-sensitive adhesive agent, an SEBS pressure-sensitive adhesive agent, an SEPS pressure-sensitive pressure-sensitive adhesive agent, or a silicone-based pressure-sensitive adhesive agent. A pressure-sensitive adhesive agent having less outgassing, which may cause haze, is preferable. A pressure-sensitive adhesive agent layer having a desired adhesive force can be formed by appropriately selecting a material having an adhesive force within the numerical range of the present invention from the commercially available known adhesive agents, or appropriately changing the raw materials and curing conditions of the pressure-sensitive adhesive agent composition. In the case of a pressure-sensitive adhesive agent composition containing a curing agent, the adhesive force of the pressure-sensitive adhesive agent layer can be varied by varying the content and type of the curing agent. Specifically, in the case of an acrylic-based pressure-sensitive adhesive agent obtained from a pressure-sensitive adhesive agent composition containing an acrylic-based polymer having a carboxyl group or a hydroxyl group in the side chain and a curing agent such as an epoxy resin or isocyanate, increasing the content of the curing agent within a certain range tends to decrease the adhesive force of the resulting pressure-sensitive adhesive agent layer. On the other hand, decreasing the content of the curing agent tends to increase the adhesive force of the resulting pressure-sensitive adhesive agent layer.

To ensure stability after attachment of the photomask and further reduce the influence of the pellicle on the photomask, the surface of the pressure-sensitive adhesive agent layer preferably has flatness of 30 µm or less. Further, as necessary, it may be formed in a cross-sectional convex shape or the like.

If the flatness of the pellicle frame is good, the deformation amount of the pellicle frame can be decreased when the pellicle is attached to the mask, and as a result, the deformation stress of the pellicle frame is decreased, and the deformation of the mask can be suppressed to be small. The "flatness" of the pellicle frame is a value calculated by measuring the height at a total of eight points, i.e., four corners and four central points of four sides of the pellicle frame, calculating a virtual plane, and subtracting the lowest point from the highest point of the distances of the points from the virtual plane. The flatness of the pellicle frame can be measured by a laser displacement meter such as a laser displacement meter having an XY-axis program stage.

A separator having peelability imparted to the surface of a PET film or the like having a thickness of about 50 to 300 µm for protection can be attached to the surface of the pressure-sensitive adhesive agent layer. This may be omitted by devising a case of a pellicle, a means for supporting a pellicle, or the like.

In the present invention, providing the pressure-sensitive adhesive agent layer having a small thickness of the pressure-sensitive adhesive agent layer and an extremely small adhesive force on the other end face (lower end face) of the pellicle frame can alleviate the stress applied to the photomask by the pellicle. Therefore, it is preferable that the PID value is as small as possible. If the PID is 30 nm or less, there is almost no influence on the fine pattern due to the deviation of the positional accuracy of the pattern, and the pellicle frame can be used as a high definition product.

Herein, as the PID, the sum of the maximum distortion amounts in the positive direction and the negative direction of the photomask before and after attaching the pellicle using FlatMaster manufactured by Corning Tropel Corporation is defined as a numerical value (magnitude) of the PID.

It is also preferable to apply an adhesive substance such as an acrylic-based pressure-sensitive adhesive agent or a silicone-based pressure-sensitive adhesive agent to the inner surface of the pellicle frame in order to capture and fix floating foreign matters. It is also preferable to form a film of a non-adhesive resin such as an acrylic-based resin or a fluorine-based resin on only the inner surface of the pellicle frame or the entire surface thereof for preventing dust generation. The films of the adhesive resin and the non-adhesive resin can be formed by a known method such as spraying, dipping, powder coating, or electrodeposition coating.

In addition, a plurality of jig holes, grooves, and the like at a plurality of places may be provided on the outer surface of the pellicle frame for applications such as handling, and it is also preferable to display a model number, a serial number, a bar code, and the like by mechanical marking or laser marking.

Further, a vent hole may be provided in the pellicle frame in order to adjust the internal air pressure after the pellicle is attached, and a filter made of a porous thin film such as PTFE may be attached to the outside thereof in order to prevent intrusion of foreign matters. In this case, the filter may be attached directly to the outer surface of the pellicle frame by providing a pressure-sensitive adhesive agent layer or the like of an appropriate material. Then, the disposal positions and the number of the vent holes and the filters, and the shapes thereof can be determined in consideration of required air permeability, convenience of handling, and the like.

The pellicle of the present invention using the pellicle frame with the above pressure-sensitive adhesive agent layer is configured to include the pellicle frame described above and a pellicle film stretched over an upper end face of the pellicle frame. The application of the pellicle is particularly effective when applied to an application for manufacturing a semiconductor device, in which distortion of a photomask is particularly problematic, but is not limited to the application. For example, possible applications include the application to any pellicle in which deformation of a photomask due to attachment of a pellicle is problematic, for example, not only an application for manufacturing a semiconductor device having a side of about 150 mm, but also an application for manufacturing a printed circuit board having a side of from 200 to 300 mm and an application for manufacturing a display such as a liquid crystal display or an organic EL display having a side of about from 500 to 2000 mm.

The pellicle film is manufactured by selecting an optimum material from materials such as a cellulose-based resin and a fluorine-based resin according to an exposure light source to be used, and selecting an optimum film thickness from a range of about from 0.1 to 10 µm from viewpoints of transmittance, mechanical strength, and the like, and an antireflection layer may be provided as necessary. In particular, if EUV light is used as the exposure light source, a silicon film or a graphene film having a film thickness of 1 µm or less can be used. As the adhesive agent for stretching the pellicle film on the upper end face of the pellicle frame, there can be used a known adhesive agent such as an acrylic-based adhesive agent, a fluorine-based adhesive agent, or a silicone-based adhesive agent. If it is difficult to handle the pellicle film singly, a pellicle film supported by a frame such as silicon can be used. In this case, for example, the pellicle can be easily manufactured by bonding the region of the frame and the pellicle frame.

The pellicle according to the present invention is attached to the substrate of the photomask by the above described pressure-sensitive adhesive agent layer. A material of the photomask substrate is typically a quartz substrate with the surface thereof coated with chromium (Cr).

As a method and conditions for attaching the pressure-sensitive adhesive agent layer to the substrate of the photomask, a mounting member such as an automatic mounter is typically used. If the load in pressing the pressure-sensitive adhesive agent layer against the photomask is smaller, the PID can be suppressed. Therefore, the attachment is recommended with a load of 5 to 25 kg/30 s. As an attaching method with a mounter, in addition to a method of pressurizing the corners (four positions), it is possible to preferably adopt a method of pressurizing the entire attaching surface with a constant load because the dispersion of the force is reduced and the PID is reduced.

The pellicle according to the present invention may be used not only as a protective member for suppressing adhesion of foreign matters to the exposure original plate but also as a protective member for protecting the exposure original plate during storage of the exposure original plate or transportation of the exposure original plate. As a method of mounting a pellicle on an exposure original plate such as a photomask to manufacture an exposure original plate with a pellicle, there are an attachment method with a pressure-sensitive adhesive agent for a photomask, an electrostatic adsorption method, a method of mechanical fixation, and the like.

The method for manufacturing a semiconductor device or a liquid crystal display (liquid crystal display plate) according to the present invention includes a step of exposing a substrate (semiconductor wafer or liquid crystal original plate) to light with the exposure original plate with a pellicle. For example, in a lithography process, which is one of the manufacturing processes of a semiconductor device or a liquid crystal display, to form a photoresist pattern corresponding to an integrated circuit or the like on a substrate, the exposure original plate with a pellicle is provided on a stepper and exposed. In general, EUV exposure uses a projection optical system in which EUV light is reflected by an exposure original plate and guided to a substrate, and these are performed under reduced pressure or vacuum. As a result, even if foreign matters adhere to the pellicle in the lithography process, the foreign matters are not imaged on the wafer coated with the photoresist, so that it is possible to prevent a short circuit, disconnection, or the like of an integrated circuit or the like due to an image of the foreign matters. Therefore, the yield in the lithography process can be improved by using the exposure original plate with a pellicle.

In general, contact exposure, proximity exposure, mirror projection exposure, step and repeat projection exposure apparatuses, step and scan projection exposure apparatuses, and the like are used for exposure apparatuses used for manufacturing semiconductor devices and the like. Herein, in the step and scan projection exposure apparatuses, for example, the circuit pattern is transferred onto a wafer while scanning the pattern of the exposure original plate with a thin slit, and thus the exposure original plate and the wafer move synchronously at a scanning speed corresponding to the magnification of the projection optical system. In this process, the pellicle attached to the exposure original plate similarly moves.

### EXAMPLES

Hereinafter, the present invention is specifically described with reference to Examples and Comparative Examples, but the present invention is not limited to the following Examples.

### [Example 1]

In Example 1, first, a pellicle frame (outer dimensions: 149 mm × 115 mm × 3.15 mm) made of an aluminum alloy was prepared. In addition, a filter hole having a diameter of 1 mm was also provided at the center of the long side of the pellicle frame.

Then, the prepared pellicle frame was washed with pure water, and then a fluorine-based adhesive agent (trade name "Cytop CT 69" manufactured by Asahi Glass Co., Ltd.) was applied to the upper end face of the pellicle frame, and an acrylic-based pressure-sensitive adhesive agent having an adhesive force of 5×10⁻³ N/cm (trade name "SK Dyne 1499M" manufactured by Soken Chemical & Engineering Co., Ltd.) was applied to the lower end face of the pellicle frame so that the thickness of the pressure-sensitive adhesive agent layer was 0.10 mm. Thereafter, the pellicle frame was heated to 130°C to cure the pressure-sensitive adhesive agent and the adhesive agent.

Thereafter, the adhesive agent layer side of the pellicle frame was attached to a pellicle film made of an amorphous fluororesin (trade name "Cytop CTX-S" manufactured by Asahi Glass Co., Ltd.) attached to an aluminum frame larger than the pellicle frame, and a portion outside the pellicle frame was removed to complete a pellicle.

The prepared pellicle was attached to a 150-mm square photomask substrate, and a long-term attachment test for 90 days was performed while maintaining the temperature at 80°C with the pellicle positioned below. The pellicle remained attached to the photomask for 90 days, and did not fall from the photomask even 120 days after the attachment.

In addition, the prepared pellicle was attached to a 150-mm square photomask substrate, and PID evaluation was performed. As a result, the PID value when the pellicle of Example 1 was attached to the photomask was 15 nm. Herein, conditions for attaching the pellicle to the photomask were set to a load of 5 kgf and a load time of 30 seconds.

### [Example 2]

In Example 2, a pellicle was prepared in the same manner as in Example 1 except that the adhesive force of the pressure-sensitive adhesive agent layer was 1×10⁻¹ N/cm.

The prepared pellicle was evaluated in the same manner as in Example 1, and as a result, in the long-term attachment test, the pellicle remained attached to the photomask for 90 days, and did not fall from the photomask even 120 days after the attachment. When the pellicle was attached to the photomask, the PID value was 20 nm.

### [Example 3]

In Example 3, a pellicle was prepared in the same manner as in Example 1 except that the adhesive force of the pressure-sensitive adhesive agent layer was 5×10⁻¹ N/cm.

The prepared pellicle was evaluated in the same manner as in Example 1, and as a result, in the long-term attachment test, the pellicle remained attached to the photomask for 90 days, and did not fall from the photomask even 120 days after the attachment. When the pellicle was attached to the photomask, the PID value was 23 nm.

### [Example 4]

In Example 4, a pellicle was prepared in the same manner as in Example 1 except that the thickness of the pressure-sensitive adhesive agent layer was 0.15 mm and the adhesive force thereof was 5×10⁻³ N/cm.

The prepared pellicle was evaluated in the same manner as in Example 1, and as a result, in the long-term attachment test, the pellicle remained attached to the photomask for 90 days, and did not fall from the photomask even 120 days after the attachment. When the pellicle was attached to the photomask, the PID value was 19 nm.

### [Example 5]

In Example 5, a pellicle was prepared in the same manner as in Example 1 except that the thickness of the pressure-sensitive adhesive agent layer was 0.15 mm and the adhesive force thereof was 1×10⁻¹ N/cm.

The prepared pellicle was evaluated in the same manner as in Example 1, and as a result, in the long-term attachment test, the pellicle remained attached to the photomask for 90 days, and did not fall from the photomask even 120 days after the attachment. When the pellicle was attached to the photomask, the PID value was 22 nm.

### [Example 6]

In Example 6, a pellicle was prepared in the same manner as in Example 1 except that the thickness of the pressure-sensitive adhesive agent layer was 0.15 mm and the adhesive force thereof was 5×10⁻¹ N/cm.

The prepared pellicle was evaluated in the same manner as in Example 1, and as a result, in the long-term attachment test, the pellicle remained attached to the photomask for 90 days, and did not fall from the photomask even 120 days after the attachment. When the pellicle was attached to the photomask, the PID value was 25 nm.

### [Example 7]

In Example 7, a pellicle was prepared in the same manner as in Example 1 except that the thickness of the pressure-sensitive adhesive agent layer was 0.20 mm and the adhesive force thereof was 5×10⁻³ N/cm.

The prepared pellicle was evaluated in the same manner as in Example 1, and as a result, in the long-term attachment test, the pellicle remained attached to the photomask for 90 days, and did not fall from the photomask even 120 days after the attachment. When the pellicle was attached to the photomask, the PID value was 19 nm.

### [Example 8]

In Example 8, a pellicle was prepared in the same manner as in Example 1 except that the thickness of the pressure-sensitive adhesive agent layer was 0.20 mm and the adhesive force thereof was 1×10⁻¹ N/cm.

The prepared pellicle was evaluated in the same manner as in Example 1, and as a result, in the long-term attachment test, the pellicle remained attached to the photomask for 90 days, and did not fall from the photomask even 120 days after the attachment. When the pellicle was attached to the photomask, the PID value was 22 nm.

### [Example 9]

In Example 9, a pellicle was prepared in the same manner as in Example 1 except that the thickness of the pressure-sensitive adhesive agent layer was 0.20 mm and the adhesive force thereof was 5×10⁻¹ N/cm.

The prepared pellicle was evaluated in the same manner as in Example 1, and as a result, in the long-term attachment test, the pellicle remained attached to the photomask for 90 days, and did not fall from the photomask even 120 days after the attachment. When the pellicle was attached to the photomask, the PID value was 26 nm.

### [Example 10]

In Example 10, a pellicle was prepared in the same manner as in Example 1 except that the thickness of the pressure-sensitive adhesive agent layer was 0.25 mm and the adhesive force thereof was 5×10⁻³ N/cm.

The prepared pellicle was evaluated in the same manner as in Example 1, and as a result, in the long-term attachment test, the pellicle remained attached to the photomask for 90 days, and did not fall from the photomask even 120 days after the attachment. When the pellicle was attached to the photomask, the PID value was 23 nm.

### [Example 11]

In Example 11, a pellicle was prepared in the same manner as in Example 1 except that the thickness of the pressure-sensitive adhesive agent layer was 0.25 mm and the adhesive force thereof was 1×10⁻¹ N/cm.

The prepared pellicle was evaluated in the same manner as in Example 1, and as a result, in the long-term attachment test, the pellicle remained attached to the photomask for 90 days, and did not fall from the photomask even 120 days after the attachment. When the pellicle was attached to the photomask, the PID value was 20 nm.

### [Example 12]

In Example 12, a pellicle was prepared in the same manner as in Example 1 except that the thickness of the pressure-sensitive adhesive agent layer was 0.25 mm and the adhesive force thereof was 5×10⁻¹ N/cm.

The prepared pellicle was evaluated in the same manner as in Example 1, and as a result, in the long-term attachment test, the pellicle remained attached to the photomask for 90 days, and did not fall from the photomask even 120 days after the attachment. When the pellicle was attached to the photomask, the PID value was 26 nm.

### [Example 13]

In Example 13, a pellicle was prepared in the same manner as in Example 1 except that the thickness of the pressure-sensitive adhesive agent layer was 0.30 mm and the adhesive force thereof was 5×10⁻³ N/cm.

The prepared pellicle was evaluated in the same manner as in Example 1, and as a result, in the long-term attachment test, the pellicle remained attached to the photomask for 90 days, and did not fall from the photomask even 120 days after the attachment. When the pellicle was attached to the photomask, the PID value was 23 nm.

### [Example 14]

In Example 14, a pellicle was prepared in the same manner as in Example 1 except that the thickness of the pressure-sensitive adhesive agent layer was 0.30 mm and the adhesive force thereof was 1×10⁻¹ N/cm.

The prepared pellicle was evaluated in the same manner as in Example 1, and as a result, in the long-term attachment test, the pellicle remained attached to the photomask for 90 days, and did not fall from the photomask even 120 days after the attachment. When the pellicle was attached to the photomask, the PID value was 23 nm.

### [Example 15]

In Example 15, a pellicle was prepared in the same manner as in Example 1 except that the thickness of the pressure-sensitive adhesive agent layer was 0.30 mm and the adhesive force thereof was 5×10⁻¹ N/cm.

The prepared pellicle was evaluated in the same manner as in Example 1, and as a result, in the long-term attachment test, the pellicle remained attached to the photomask for 90 days, and did not fall from the photomask even 120 days after the attachment. When the pellicle was attached to the photomask, the PID value was 30 nm.

### [Comparative Example 1]

In Comparative Example 1, a pellicle was prepared in the same manner as in Example 1 except that an acrylic-based pressure-sensitive adhesive agent (SK Dyne 1170, manufactured by Soken Chemical & Engineering Co., Ltd.) having an adhesive force of 1 N/cm was used and the adhesive agent was applied to form a pressure-sensitive adhesive agent layer so as to have a thickness of 0.10 mm.

The prepared pellicle was attached to a 150-mm square photomask substrate, and a long-term attachment test for 90 days was performed while maintaining the temperature at 80°C with the pellicle positioned below. The pellicle remained attached to the photomask for 90 days, and did not fall from the photomask even 120 days after the attachment.

In addition, the prepared pellicle was attached to a 150-mm square photomask substrate, and PID evaluation was performed. As a result, the PID value when the pellicle of Comparative Example 1 was attached to the photomask was 34 nm. Herein, conditions for attaching the pellicle to the photomask were set to a load of 5 kgf and a load time of 30 seconds.

### [Comparative Example 2]

In Comparative Example 2, a pellicle was prepared in the same manner as in Example 1 except that the thickness of the pressure-sensitive adhesive agent layer was 0.35 mm and the adhesive force thereof was 5×10⁻³ N/cm.

The prepared pellicle was evaluated in the same manner as in Example 1, and as a result, in the long-term attachment test, the pellicle remained attached to the photomask for 90 days, and did not fall from the photomask even 120 days after the attachment. When the pellicle was attached to the photomask, the PID value was 33 nm.

### [Comparative Example 3]

In Comparative Example 3, a pellicle was prepared in the same manner as in Example 1 except that the thickness of the pressure-sensitive adhesive agent layer was 0.35 mm and the adhesive force thereof was 5×10⁻¹ N/cm.

The prepared pellicle was evaluated in the same manner as in Example 1, and as a result, in the long-term attachment test, the pellicle remained attached to the photomask for 90 days, and did not fall from the photomask even 120 days after the attachment. When the pellicle was attached to the photomask, the PID value was 39 nm.

### [Comparative Example 4]

In Comparative Example 4, a pellicle was prepared in the same manner as in Example 1 except that the thickness of the pressure-sensitive adhesive agent layer was 0.50 mm and the adhesive force thereof was 5×10⁻³ N/cm.

The prepared pellicle was evaluated in the same manner as in Example 1, and as a result, in the long-term attachment test, the pellicle remained attached to the photomask for 90 days, and did not fall from the photomask even 120 days after the attachment. When the pellicle was attached to the photomask, the PID value was 43 nm.

### [Comparative Example 5]

In Comparative Example 5, a pellicle was prepared in the same manner as in Example 1 except that the thickness of the pressure-sensitive adhesive agent layer was 0.50 mm and the adhesive force thereof was 5×10⁻¹ N/cm.

The prepared pellicle was evaluated in the same manner as in Example 1, and as a result, in the long-term attachment test, the pellicle remained attached to the photomask for 90 days, and did not fall from the photomask even 120 days after the attachment. When the pellicle was attached to the photomask, the PID value was 42 nm.

**[Table 1]**

| | No. | Thickness of pressure-sensitive adhesive agent (mm) | Adhesive force (N/cm) | PID (nm) |
|---|---|---|---|---|
| Example | 1 | 0.10 | 5×10⁻³ | 15 |
| | 2 | | 1×10⁻¹ | 20 |
| | 3 | | 5×10⁻¹ | 23 |
| | 4 | 0.15 | 5×10⁻³ | 19 |
| | 5 | | 1×10⁻¹ | 22 |
| | 6 | | 5×10⁻¹ | 25 |
| | 7 | 0.20 | 5×10⁻³ | 19 |
| | 8 | | 1×10⁻¹ | 22 |
| | 9 | | 5×10⁻¹ | 26 |
| | 10 | 0.25 | 5×10⁻³ | 23 |
| | 11 | | 1×10⁻¹ | 20 |
| | 12 | | 5×10⁻¹ | 26 |
| | 13 | 0.30 | 5×10⁻³ | 23 |
| | 14 | | 1×10⁻¹ | 23 |
| | 15 | | 5×10⁻¹ | 30 |
| Comparative Example | 1 | 0.10 | 1 | 34 |
| | 2 | 0.35 | 5×10⁻³ | 33 |
| | 3 | | 5×10⁻¹ | 39 |
| | 4 | 0.50 | 5×10⁻³ | 43 |
| | 5 | | 5×10⁻¹ | 42 |

## Claims

1. A pellicle frame with a pressure-sensitive adhesive agent layer, the pellicle frame having one end face on which a pellicle film is provided and another end face on which a pressure-sensitive adhesive agent layer to be attached to a photomask is provided, wherein the pressure-sensitive adhesive agent layer has a thickness of from 0.10 to 0.30 mm, and the pressure-sensitive adhesive agent layer has an adhesive force of from 5×10⁻³ to 5×10⁻¹ N/cm.

2. The pellicle frame with a pressure-sensitive adhesive agent layer of claim 1, wherein the pressure-sensitive adhesive agent layer contains an acrylic-based pressure-sensitive adhesive agent.

3. The pellicle frame with a pressure-sensitive adhesive agent layer of claim 1, wherein the pressure-sensitive adhesive agent layer contains a silicone-based pressure-sensitive adhesive agent.

4. The pellicle frame with a pressure-sensitive adhesive agent layer of any one of claims 1 to 3, wherein a peelable separator is provided on a surface of the pressure-sensitive adhesive agent layer.

5. A pellicle, wherein a pellicle film is provided on the one end face of the pellicle frame with a pressure-sensitive adhesive agent layer of any one of claims 1 to 4.

6. A photomask with a pellicle, wherein the pellicle of claim 5 is provided on a photomask.

7. An exposure method, wherein exposure is performed with the photomask with a pellicle of claim 6.

8. A method for manufacturing a semiconductor device, the method comprising a step of performing exposure with the photomask with a pellicle of claim 6.

9. A method for manufacturing a liquid crystal display, the method comprising a step of performing exposure with the photomask with a pellicle of claim 6.
